Europäisches Patentamt

European Patent Office    (11) Numéro de publication: **0 018 918**

Office européen des brevets    **B1**

(19)

(12) **FASCICULE DE BREVET EUROPEEN**

(45) Date de publication du fascicule du brevet: **25.05.83**   (51) Int. Cl.³: **H 03 K 13/05**

(21) Numéro de dépôt: **80400607.0**

(22) Date de dépôt: **06.05.80**

(54) **Circuit pour conversion numérique-analogique à caractéristique sinusoidale.**

(30) Priorité: **07.05.79 FR 7911456**

(43) Date de publication de la demande:
**12.11.80 Bulletin 80/23**

(45) Mention de la délivrance du brevet:
**25.05.83 Bulletin 83/21**

(84) Etats contractants désignés:
**AT BE CH DE FR GB IT LI LU NL SE**

(56) Documents cités:
**FR - A - 2 353 998**
**US - A - 3 688 303**
**US - A - 3 831 168**

(73) Titulaire: **CENTRE NATIONAL D'ETUDES SPATIALES**
**129, Rue de l'Université**
**F-75007 Paris (FR)**

(72) Inventeur: **Burnel, Yves A.P.M.**
**7, rue Kepler**
**F-31500 Toulouse (FR)**

(74) Mandataire: **Corre, Jacques Denis Paul et al,**
**Cabinet Regimbeau 26, Avenue Kléber**
**F-75116 Paris (FR)**

Courier Press, Leamington Spa, England.

# 0018918

## Circuit pour conversion numérique-analogique à caractéristique sinusoïdale

L'invention concerne généralement la conversion numérique-analogique à caractéristique sinusoïdale, qui s'applique aux machines convertissant des informations numériques en des signaux identiques à ceux que produisent des synchromachines électromécaniques, et réciproquement, la conversion d'analogique à caractéristique sinusoïdale en numérique.

La demande de brevet Singer FR 2 353 998 décrit un circuit pour conversion numérique-analogique à caracteristique sinusoïdale, comprenant:

— une borne destinée à recevoir une tension de référence définissant l'échelle analogique de conversion,
— des bornes d'entrée numérique destinées à recevoir une série de chiffres représentant, dans un ordre de poids préétabli, la valeur numérique d'un angle au moins en fractions de quart de cercle.
— un amplificateur-inverseur,
— un premier jeu de résistances montées pour former un diviseur de tension dont une borne extrême est reliée à la sortie de l'amplifcateur-inverseur et la borne intermédiaire est reliée à l'entrée inverseuse de l'amplificateur-inverseur,
— un second jeu de résistances formant un réseau convertisseur numérique-analogique et
— un ensemble de commutation capable d'interconnecteur sélectivement, sous l'effet de moyens de commande de commutation en fonction des chiffres d'entrée, le premier et le second jeu de résistances, de manière à fournir sur la sortie analogique de l'amplificateur-inverseur une approximation par segments de droite d'une fonction sinusoïdale de la valeur numérique d'entrée.

La présente invention a pour but d'améliorer la précision, et la reproductibilité de la loi de transformation sinusoïdale, par rapport à ce dispositif antérieur.

A cet effet, selon l'invention, le premier jeu de résistances comprend une résistance $(Rp_o)$ reliée d'un côté à la sortie de l'amplificateur-inverseur, ainsi qu'un nombre m supérieur ou égal à 1 de diviseurs résistifs $(Rs_c, Rp_c)$ montés entre la borne de tension de référence et la sortie de l'amplificateur-inverseur, l'ensemble de commutation comprend un premier dispositif commutateur comprenant au moins deux contacts $(S_d)$ connectés d'une part respectivement à l'autre côté de la résistance première nommée $(Rp_o)$ ainsi qu'au point mileu du ou des diviseurs résistifs $(Rs_c, Rp_c)$, et d'autre part en commun à l'entrée de l'amplificateur-inverseur; le second jeu de résistances, monté en parallèle entre la borne de tension de référence et l'entrée de l'amplificateur-inverseur, comprend d'autres résistances mises en série sur des contacts respectifs formant un second dispositif commutateur au sein de l'ensemble de commutation; et les moyens de commande de commutation agissent sur l'état des contacts du premier et du second commutateur respectivement en fonction d'au moins un poids supérieur et des autres poids inférieurs de la valeur numérique appliquée aux bornes d'entrée, un et un seul des contacts du premier commutateur étant fermé à chaque fois; enfin, K désignant un facteur prédéterminé, $\varepsilon$ une petite quantité d'approximation choisie à l'avance, et $R_{min}$ représentant la résistance équivalente à l'ensemble parallèle des résistances $(R_1$ à $R_8)$ dudit second jeu,

— la résistance $Rp_o$ est sensiblement égale à

$$\frac{K}{U} \cdot R_{min} \cdot \sin\left(\frac{\pi}{2} \cdot \frac{1}{m+1} + \frac{\varepsilon}{2}\right)$$

— la ou les résistances $Rp_c$ sont, d'après la valeur de leur indice c, sensiblement égales à

$$\frac{K}{U} \cdot R_{min} \cdot \left[\sin\left(\frac{\pi}{2} \cdot \frac{c+1}{m+1} + \frac{\varepsilon}{2}\right) - \sin\left(\frac{\pi}{2} \cdot \frac{c}{m+1} + \frac{\varepsilon}{2}\right)\right]$$

— et la ou les résistances $Rs_c$ sont, d'après la valeur de leur indice c, sensiblement égales à

$$\frac{U}{K} \cdot \frac{1}{\sin\left(\frac{\pi}{2} \cdot \frac{c}{m+1} + \frac{\varepsilon}{2}\right)} \cdot Rp_c$$

La sortie analogique de l'amplificateur constitue alors une approximation par segments de droite sur un quadrant d'une fonction sinusoïdale de la valeur numérique d'entrée. Par fonction sinusoïdale, on entend ici la fonction sinus la fonction cosinus ainsi que leurs combinaisons linéaires.

**OO18918**

Selon une autre caractéristiques de l'invention, les résistances dudit second jeu sont entre elles comme les puissances successives de deux, et le nombre m est égal à 3 ou 7. Dans un mode de réalisation préférentiel, les moyens de commande agissent directement sur les contacts ($S_1$ à $S_8$) du second commutateur, et par l'intermédiaire d'un décodeur sur les contacts ($S_d$) du premier commutateur, un et un seul de ces contacts étant fermé, en fonction du ou des poids supérieurs de la valeur numérique d'entrée.

Selon un autre aspect de l'invention, le circuit proposé comporte un second amplificateur-inverseur connecté à la sortie du premier, et agencé pour délivrer une sortie de même amplitude que lui, mais de signe opposé.

On notera qu'en complémentant les chiffres $b_1$ à $b_{n-2}$ constituant la grandeur numérique d'entrée, on obtient la fonction cosinus au lieu de la fonction sinus.

Jusqu'à présent, on obtient une caractéristique sinusoïdale seulement sur le premier quadrant du cercle trigonométrique. Très avantageusement, la quantité numérique d'entrée à convertir comporte encore deux poids supérieurs à tous les autres, indiquant dans quel quadrant du cercle trigonométrique se situe la grandeur d'entrée. Le circuit proposé se complète alors par des moyens aptes à complémenter tous les autres poids de la grandeur numérique d'entrée, et par des moyens de sélection capables de choisir d'effectuer ou non cette complementation, ainsi que de prendre la sortie de l'un ou l'autre des deux amplificateurs-inverseurs en fonction des deux poids les plus importants qui définissent le quadrant.

Dans une première application préferentielle, le circuit comporte donc un second circuit semblable au premier, mais connecté à la sortie des moyens qui sont aptes à complémenter tous les autres poids, et les moyens de sélection sont connectés aux deux circuits semblables, ce qui permet de fournir en même temps le sinus et le cosinus de la grandeur d'entrée. On obtient ainsi un dispositif convertisseur numérique-résolveur.

Avantageusement, en ajoutant à la sortie de ce convertisseur numérique-résolveur un transformateur de Scott, on obtient un convertisseur de numérique aux trois grandeurs d'entrée utilisées dans une synchromachine triphasée.

Une autre application de l'invention vise un convertisseur résolveur-numérique, qui réalise donc la convertion inverse, à partir de deux tensions analogiques d'entrée respectivement représentatives du sinus et du cosinus d'un angle $\varphi$. Cette application fait usage de deux circuits du type proposé, dont l'un est équipé en outre d'un moyen pour complémenter sa grandeur numérique d'entrée. Il s'y ajoute un compteur-decompteur apte à fournir en parallèle n chiffres $b_1$ à $b_n$ de poids croissants, destinés à représenter la valeur numérique d'un angle $\theta$, ainsi qu'un circuit d'aiguillage d'entrée qui réagit aux poids supérieurs de cet angle numérique $\theta$ en appliquant selon une loi de commutation préétabli l'un et l'autre des signaux d'entrée à l'un et l'autre des premier et second circuits numériques-analogiques, comme tension de référence. Les deux circuits en question reçoivent les autres poids du compteur-décompteur comme entrée numérique, l'un directement, et l'autre à travers la complémentation qui lui est associée. Un circuit d'addition analogique combine les sorties des deux circuits numériques-analogiques, le circuit d'aiguillage et ce circuit d'addition analogique étant agencés avec des polarités telles que la sortie additive soit de la forme

$$\sin \varphi \cos\theta - \sin \theta \cos \varphi = \sin(\varphi - \theta).$$

Enfin, un moyen de servo-commande fait évoluer le compteur-décompteur de manière à annuler la sortie additive analogique, ce qui fournit finalement une valeur numérique $\theta$ représentative de l'angle d'entrée $\varphi$.

Dans la plupart des cas, les deux tensions analogiques d'entrée sont constituées respectivement par une même fréquence porteuse modulée en amplitude suivant le sinus et le cosinus de l'angle $\varphi$. Le moyen de servo-commande comprend alors un démodulateur synchrone piloté par cette fréquence porteuse.

Dans un mode de réalisation particulier, le moyen de servo-commande comprend un détecteur de polarité qui définit si le compteur-décompteur est commandé en comptage ou en décomptage, ainsi qu'un convertisseur tensio-fréquence, de préférence à caractéristique non linéaire, qui définit la fréquence d'horloge appliquée à ce même compteur-décompteur.

D'autres caractéristiques et avantages de l'invention apparaîtront à la lecture de la description détaillée qui va suivre, faite en référence aux dessins annexés, donnés uniquement pour illustrer à titre non limitatif un mode de réalisation préférentiel et une application de l'invention, et sur lesquels:

— la figure 1 illustre le schéma électrique de principe du circuit de base proposé;
— la figure 2 est un diagramme illustrant comment le circuit proposé réalise un approximation par segments de droite de la fonction sinus $\theta$ sur un quart de cercle;
— la figure 3 illustre un convertisseur numérique-résolveur faisant usage de deux circuits selon la figure 1;
— la figure 4 illustre le schéma électrique détaillé du sélecteur de quadrant SQ1 de la figure 3, tandis que la figure 5 illustre la table de vérité de ce même sélecteur;

3

— la figure 6 illustre un convertisseur résolveur-numérique faisant usage des deux circuits du type proposé sur la figure 1; et

— la figure 7 illustre le schéma électrique détaillé du sélecteur de quadrant SQ2 de la figure 6, tandis que la figure 8 en donne la table de vérité.

La conversion de numérique à analogique sinusoïdal s'effectue à partir d'une tension de référence notée U.

Les huit bits les moins significatifs du nombre à convertir, notés $b_1$ à $b_8$, commandent l'état de huit interrupteurs $S_1$ à $S_8$, respectivement mis en série sur des résistances $R_1$ à $R_8$. Pour la fonction sinus, chaque interrupteur est ouvert lorsque le bit correspondant vaut zéro, et fermé lorsqu'il vaut un.

De leur côté, les résistances valent ici r pour $R_8$, 2.r pour $R_7$ et ainsi de suite jusqu'à 128.r pour $R_1$, formant un convertisseur numérique-analogique à résistances pondérées en puissance de deux. Ces résistances sont d'un côté reliées à la borne de tension de référence U, et de l'autre à l'entrée inverseuse d'un amplificateur différentiel $A_1$, dont l'entrée non-inverseuse est reliée à la masse à travers une résistance Ra. On note $R_{min}$ la résistance équivalente à l'ensemble des résistances $R_1$ à $R_8$ mises en parallèle.

Deux bits plus significatifs $b_9$ et $b_{10}$ du nombre à convertir sont appliqués à un décodeur DCR, capable d'en déduire quatre états différentes pour fermer un et un seul quatre interrupteurs $Sd_{00}$ à $Sd_{11}$. La table de vérité du décodeur est la suivante:

| $b_{n-1}$ $(b_{10})$ | $b_{n-2}$ $(b_9)$ | Interrupteur fermé |
|---|---|---|
| 0 | 0 | $Sd_{00}$ |
| 0 | 1 | $Sd_{01}$ |
| 1 | 0 | $Sd_{10}$ |
| 1 | 1 | $Sd_{11}$ |

L'interrupteur $Sd_{00}$, lorsqu'il est fermé, vient brancher une résistance $Rp_0$ entre la sortie et l'entrée inverseuse de l'amplificateur $A_1$.

Entre la sortie du même amplificateur et la borne de tension de référence sont également montés trois diviseurs de tension, avec chacun une résistance $Rp_c$ côté sortie de l'amplificateur et une résistance $Rs_c$ côté tension de référence, l'indice c variant ici de 1 à 3 (avec m=3).

Lorsqu'il est fermé l'interrupteur $Sd_{01}$ vient relier l'entrée inverseuse de l'amplificateur $A_1$ au point milieu du diviseur $Rs_1$—$Rp_1$. Il en est de même pour les interrupteurs $Sd_{10}$ et $Sd_{11}$, respectivement avec les diviseurs $Rs_2$—$Rp_2$ et $Rs_3$—$Rp_3$.

On observera que la résistance $Rp_0$ joue le même rôle que les résistances $Rp_c$, si l'on admet qu'elle forme diviseur de tension avec une résistance $Rs_0$ (non câblee) de valuer infinie. La résistance $Rp_0$ est donc l'une des résistances $Rp_c$, avec c=0.

La valeur des résistances $Rp_c$ (c variant de zéro à m, avec ici m=3) et donnée par l'expression suivante

$$Rp_c = \frac{K}{U} \cdot R_{min} \cdot [\sin(\frac{\pi}{2} \cdot \frac{c+1}{m+1} + \frac{\varepsilon}{2}) - \sin(\frac{\pi}{2} \cdot \frac{c}{m+1} \cdot \frac{\varepsilon}{2})]$$

d'où pour $Rp_0$,

$$Rp_0 = \frac{K}{U} \cdot R_{min} \cdot \sin(\frac{\pi}{2} \cdot \frac{1}{m+1} + \frac{\varepsilon}{2}).$$

Dans ces expressions, K désigne un facteur prédéterminé, et $\varepsilon$ une petite quantité d'approximation choisie à l'avance. La quantité $\varepsilon$ est reliée à la résolution angulaire minimum désirée par la relation

$$\varepsilon = \frac{\theta}{2^n}$$

où n est le nombre de bits d'entrée avec ici n=12. On notera que cette quantité $\varepsilon$ est ici répartie en deux moitiés

$$\frac{\varepsilon}{2}$$

**0018918**

qui interviennent également sur les deux termes en sinus dans l'expression de $Rp_c$. Il est bien entendu possible d'adopter une répartition différente.

Les résistances $Rp_c$ seront choisies avec des tolérances telles que celles indiquées par la relation suivante, en fonction de la valeur de c:

$$\pm \frac{1}{2} \cdot \frac{\sin\left(\frac{\pi}{2} \cdot \frac{c+1}{m+1} + \frac{\varepsilon}{2}\right) - \sin\left(\frac{\pi}{2} \cdot \frac{c+1}{m+1}\right)}{\sin\left(\frac{\pi}{2} \cdot \frac{c+1}{m+1}\right) - \sin\left(\frac{\pi}{2} \cdot \frac{c}{m+1}\right)}$$

De leur côté, les résistances $Rs_c$ sont définies par l'expression suivante, avec c variant de 0 à m et ici m=3:

$$\frac{U}{K} \cdot \frac{1}{\sin\left(\frac{\pi}{2} \cdot \frac{c}{m+1} + \frac{\varepsilon}{2}\right)} \cdot Rp_c$$

On retrouve bien une résistance $Rs_0$ infinie. La tolérance sur les résistances $Rs_c$ s'écrit:

$$\pm \frac{1}{2} \cdot \frac{\sin\left(\frac{\pi}{2} \cdot \frac{c}{m+1} + \frac{\varepsilon}{2}\right) - \sin\left(\frac{\pi}{2} \cdot \frac{c}{m+1}\right)}{\sin\left(\frac{\pi}{2} \cdot \frac{c}{m+1}\right)}$$

Avec la disposition qui vient d'être décrite, on obtient en sortie de l'amplificateur $A_1$ une tension analogique représentative de $+ \sin \theta$, $\theta$ étant un angle variable sur un quart de cercle

$$\text{(de 9 à } \frac{\pi}{2} = 90°\text{)}.$$

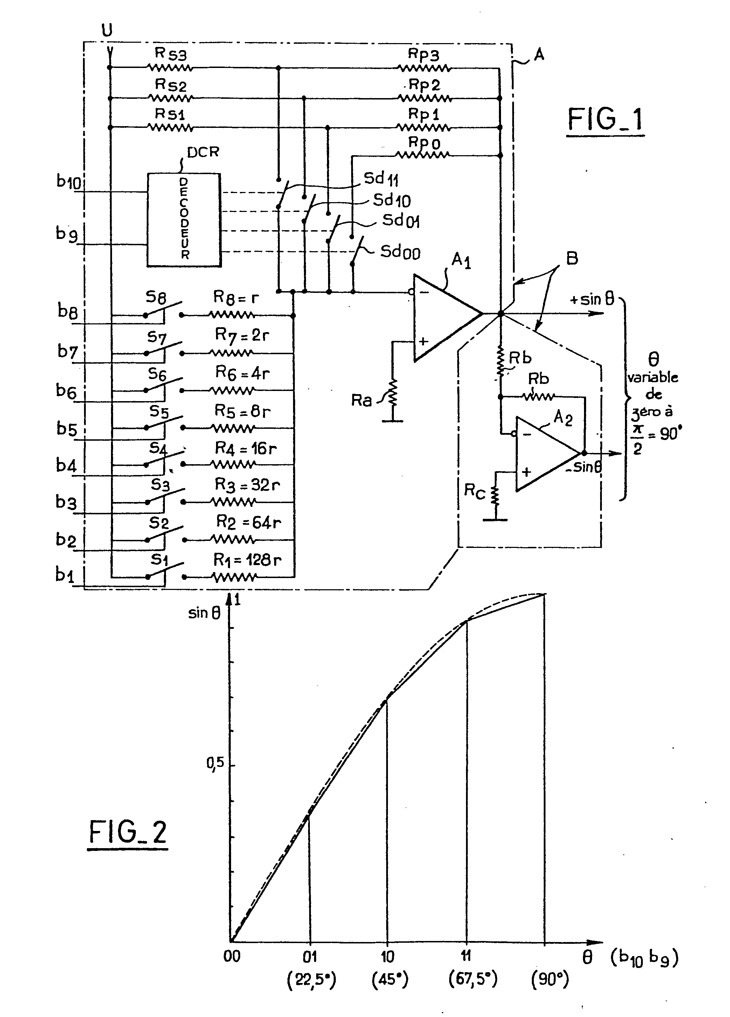

L'approximation par segments de droite est illustrée sur la figure 2, pour m=3.

Sur la figure 1, la sortie de l'amplificateur $A_1$ est reliée par une résistance Rb à l'entrée inverseuse d'un autre amplificateur $A_2$, elle-même reliée à sa sortie par une autre résistance de valeur Rb, ce qui lui donne un gain $-1$. L'entrée non-inverseuse de l'amplificateur $A_2$ est reliée à la masse à travers une résistance Rc. Cet amplificateur $A_2$ délivre en sortie $-\sin \theta$, avec $\theta$ variable de 0 à

$$\frac{\pi}{2} = 90°.$$

Dans un mode de réalisation particulier, les éléments du circuit sont les suivants:

$R_8 = R_{(n-4)} = 50 \text{ k}\Omega \pm 1°/_{oo}$
$R_7 = R_{(n-5)} = 100 \text{ k}\Omega \pm 1°/_{oo}$
$R_6 = R_{(n-6)} = 200 \text{ k}\Omega \pm 2°/_{oo}$
$R_5 = R_{(n-7)} = 400 \text{ k}\Omega \pm 5°/_{oo}$
$R_4 = R_{(n-8)} = 800 \text{ k}\Omega \pm 1°/_{o}$
$R_3 = R_{(n-9)} = 1,6 \text{ M}\Omega \pm 2°/_{o}$
$R_2 = R_{(n-10)} = 3,2 \text{ M}\Omega \pm 5°/_{o}$
$R_1 = R_{(n-11)} = 6,4 \text{ M}\Omega \pm 10°/_{o}$
$Rp_0 = 9,6220 \text{ k}\Omega \pm 0.5°^{l}/_{oo}$
$Rp_1 = 8,1381 \text{ k}\Omega \pm 0,5°/_{oo}$
$Rp_2 = 5,4377 \text{ k}\Omega \pm 0,2°/_{oo}$
$Rp_3 = 1,9032 \text{ k}\Omega \pm 0,2°/_{oo}$
$Rs_0 = \text{infinie}$
$Rs_1 = 21,2275 \text{ k}\Omega \pm 0,2°/_{oo}$

$Rs_2 = 7,6802 \ k\Omega \pm 0.2\%_{oo}$
$Rs_3 = 2,0593 \ k\Omega \pm 0,2\%_{oo}$
$S_1$ à $S_4$ quadruple interrupteur DG 201 Siliconix
$S_5$ et $S_6$ double interrupteur DG 182 Siliconix
$S_7$ et $S_8$ double interrupteur DG 180 Siliconix
$Sd_{00}$ à $Sd_{11}$ quadruple interrupteur DG 509 Siliconix
décodeur DM 54.155 NS
$A_1$ et $A_2$ modèle LM 101 A Sescosem
$Ra = 2,2 \ k\Omega; \ 5\%_o$
$Rb = 10 \ k\Omega; \ 0,2 \ \%_{oo}$
$Rc = 4,7 \ k\Omega; \ 5\%_o$

Ce mode de réalisation particulier utilise une approximation de la fonction sinus par quatre segments de droite sur

$$90° = \frac{\pi}{2} \ (\text{avec } m=3).$$

Bien entendu, on peut facilement améliorer la précision en utilisant huit segments de droite, donc avec $m=7$. Par ailleurs, en complémentant les bits $b_1$ à $b_{n-2}$, on obtient $\cos \theta$ au lieu de $\sin \theta$.

On observera qu'un seul à la fois des commutateurs $Sd_{00}$ à $Sd_{11}$—qui sont du type à transistor effet de champ, de préférence métal-oxyde-semiconducteur ou analogues, vient en série dans la maille d'entrée de l'amplificateur-inverseur. En ajoutant en série sur chaque interrupteur une résistance de faible valeur choisie on peut compenser aisément les tolérances de fabrication quant à la résistance résiduelle des interrupteurs à effet de champ—et même effectuer une compensation de température en prenant une faible résistance dont l'évolution en fonction de la température équilibre les variations en température de la résistance résiduelle des interrupteurs.

Le circuit de base de la figure 1 est susceptible de nombreuses applications, dont on décrira maintenant des exemples. Pour ceux-ci, on tiendra compte des éléments inclus dans le cadre A en trait d'axe de la figure 1. Lorsqu'il s'y ajoute le second amplificateur $A_2$, le circuit sera noté B.

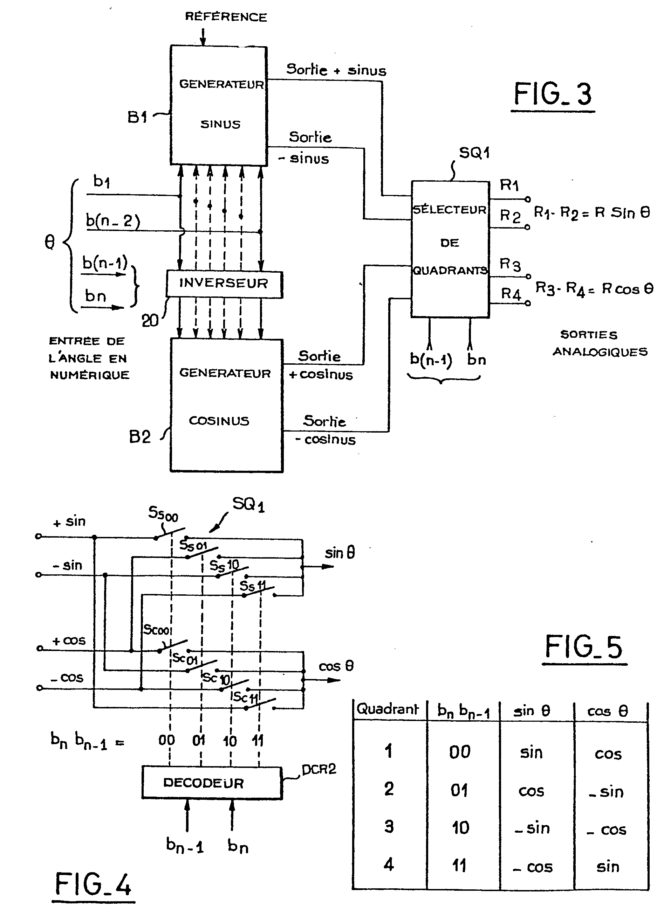

La figure 3 illustre un circuit convertisseur numérique-résolveur (à sortie en sinue et cosinus), capable de convertir un angle de numérique à analogique sinusoidal sur une circonférence complète (0 à 360°, ou 0 à $2\pi$ radians).

Les bits d'entrée $b_1$ à $b_{n-2}$ sont appliqués directement à un premier circuit B1 selon la figure 1. Après complémentation individuelle dans un inverseur 20, ils sont appliqués à un second circuit B2 selon la figure 1. Ces bits $b_1$ à $b_{n-2}$ désignant un angle $\theta$ compris entre 0 et 90°, la sortie du circuit B1 est $+\sin \theta$ ou $-\sin \theta$, et celle du circuit B2 est $+\cos \theta$ ou $-\cos \theta$.

Ces quatre signaux sont appliqués à un sélecteur de quadrant SQ1, qui en déduit les grandeurs de sortie $R \sin \theta$ et $R \cos \theta$, en fonction de $b_{n-1} = b_{11}$ et $b_n = b_{12}$, bits de quadrant de la grandeur numérique d'entrée, de poids encore supérieure à tous les autres bits. Maintenant $\theta$ est variable sur un tour complet, exprimé en binaire par 100 000 000 000, en degrés par 360° ou en radians par $2\pi$.

Le schéma détaillé du sélecteur SQ1 est donné par la figure 4, et sa table de vérité par la figure 5. Les bits $b_{n-1}$ sont appliqués à un décodeur DCR2 dont les quatre sorties 00 à 11 (en binaire) commandent des interrupteurs Ss et Sc de même indice.

— Si $b_n b_{n-1} = 00$, l'angle $\theta$ est compris dans le premier quadrant, $Ss_{00}$ et $Sc_{00}$ sont fermés, les sorties de SQ1 étant $\sin \theta$ et $\cos \theta$;

— Si $b_n b_{n-1} = 01$, l'angle $\theta$ est compris dans le second quadrant, $Ss_{01}$ et $Sc_{01}$ sont fermés, les sorties de SQ1 étant

$$\sin \theta = \cos(\theta - \frac{\pi}{2}) \ \text{et} \ \cos \theta = -\sin(\theta - \frac{\pi}{2});$$

— Si $b_n b_{n-1} = 10$, l'angle $\theta$ est compris dans le troisième quadrant, $Ss_{10}$ et $Sc_{10}$ sont fermés, les sorties de SQ1 étant

$$\sin \theta = -\sin(\theta - \pi) \ \text{et} \ \cos \theta = -\cos(\theta - \pi);$$

— Si $b_n b_{n-1} = 11$, l'angle $\theta$ est compris dans le quatrième quadrant, $Ss_{11}$ et $Sc_{11}$ sont fermés, les sorties de SQ1 étant

$$\sin \theta = -\cos(\theta - \frac{3\pi}{2}) \ \text{et} \ \cos \theta = \sin(\theta - \frac{3\pi}{2}).$$

6

On voit donc que deux circuits selon l'invention permettent d'obtenir, ensemble ou séparément les deux grandeurs $\sin \theta$ et $\cos \theta$, l'angle $\theta$ variant sur toute la circonférence.

En obtenant simultanément les deux sorties R $\sin \theta$ et R $\cos \theta$, on réalise un convertisseur numérique-résolveur, utilisable pour la commande numérique de machines à deux phases en sinus et cosinus.

En branchant un transformateur de Scott aux sorties $\sin \theta$ et $\cos \theta$, on passe en triphasé, ce qui permet la commande d'une synchromachine triphasée.

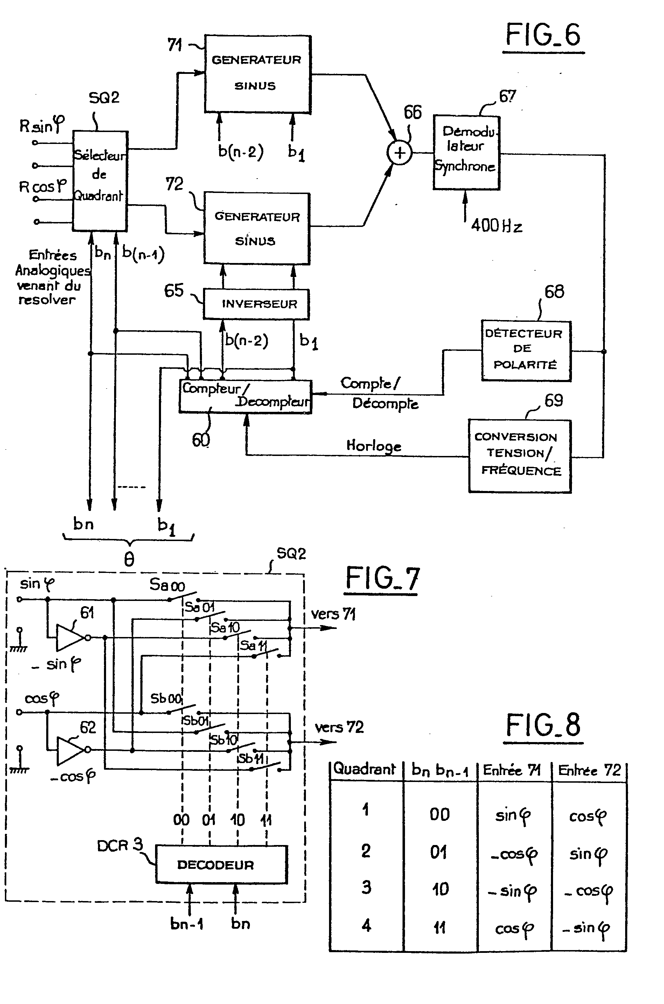

L'invention permet aussi la conversion inverse de résolveur à numérique, à l'aide du circuit illustré sur la figure 6. Les entrées analogiques R $\sin \varphi$ et R $\cos \varphi$ sont données par un résolveur. Elles sont appliquées à un sélecteur de quadrant SQ2 dont le schéma détaillé est donné sur la figure 7. Dans ce sélecteur de quadrant, deux amplificateurs-inverseurs 61 et 62 fournissent respectivement $-\sin \varphi$ et $-\cos \varphi$ à partir de $+\sin \varphi$ et $+\cos \varphi$; à côté de cela, un décodeur DCR3 reçoit deux bits de poids supérieur $b_n$ et $b_{n-1}$ venant d'un compteur-décompteur 60. Les quatre sorties 00 à 11 du décodeur commandent respectivement des interrupteurs $Sa_{00}$ et $Sb_{00}$, $Sa_{01}$ et $Sb_{01}$, $Sa_{10}$ et $Sb_{10}$, $Sa_{11}$ et $Sb_{11}$.

La table de vérité de la figure 8 donne la valeur de chacune des deux sorties du sélecteur SQ2, vers deux circuits 71 et 72 semblables au circuit A de la figure 1 (sans l'amplificateur de sortie A2).

Le compteur-décompteur 60 déjà cité fournit des bits $b_1$ à $b_n$, dont $b_1$ à $b_{n-2}$ sont appliqués directement comme entrée numérique d'angle au circuit 71, et après complémentation en 65 au circuit 72. L'ensemble des bits $b_1$ à $b_n$ définit numériquement un angle $\theta$, dont les deux bits de poids supérieur ont été appliqués au sélecteur de quadrant ou circuit d'aiguillage SQ2.

Enfin, un additionneur (ou soustracteur, en variante) analogique 66 vient ajouter les deux sorties analogiques des circuits 71 et 72.

On vérifie aisément que la sortie du circuit 66 est:

$$\sin \varphi \cos \theta - \sin \theta \cos \varphi = \sin(\varphi - \theta)$$

Cette sortie est ici appliquée à un démodulateur synchrone 67 piloté par un signal local à 400 Hz, représentant la fréquence porteuse des signaux résolveurs $\sin \varphi$ et $\cos \varphi$ appliqués à l'entrée. Si ceux-ci ne sont pas introduits sous forme de modulation, mais directement en grandeur analogique, le démodulateur 67 peut être supprimé.

La sortie du circuit 67 (ou 66, le cas échéant) est appliquée d'une part à un détecteur de polarité 68, qui commande le comptage ou le décomptage par le compteur-décompteur 60, et d'autre part à un convertisseur tension fréquence 69 (de préférence non linéaire avec un gain supérieur aux faibles tensions d'entrée), qui définit la fréquence appliquée au compteur 60.

Cet ensemble constitue une boucle de servo-commande qui fait évoluer le compteur-décompteur de manière à annuler la sortie du circuit 66, obtenant donc $\theta = \varphi$. La valeur numérique de $\theta$, $b_1$ à $b_n$ représente donc l'angle introduit sous forme analogique.

Bien entendu, la présente invention n'est pas limitée aux modes de réalisation ni application décrits. En particulier, la tension de référence U peut être variable, par exemple sinusoïdale, plutôt que continue.

**Revendications**

1. Circuit pour conversion numérique-analogique à caractéristique sinusoïdale, du type comprenant:

— une borne destinée à recevoir une tension de référence U définissant l'échelle analogique de conversion,

— des bornes d'entrée numérique destinées à recevoir une série ($b_1$ à $b_{n-2}$) de chiffres représentant, dans un ordre de poids préétabli, la valeur numérique d'un angle au moins en fractions de quart de cercle,

— un amplificateur-inverseur;

— un premier jeu de résistances montées pour former un diviseur de tension dont une borne extrême est reliée à la sortie de l'amplificateur-inverseur et la borne intermédiaire est reliée à l'entrée inverseuse de l'amplificateur-inverseur,

— un second jeu de résistances formant un réseau convertisseur numérique-analogique et

— un ensemble de commutation capable d'interconnecter sélectivement, sous l'effet de moyens de commande de commutation en fonction des chiffres d'entrée, le premier et le second jeu de résistances, de manière à fournir sur la sortie analogique de l'amplificateur-inverseur une approximation par segments de droite d'une fonction sinusoïdale de la valeur numérique d'entrée,

caractérisé par le fait que le premier jeu de résistances comprend une résistance ($Rp_o$) reliée d'un côté à la sortie de l'amplificateur-inverseur, ainsi qu'un nombre m supérieur ou égal à 1 de diviseurs résistifs ($Rs_c$, $Rp_c$) montés entre la borne de tension de référence et la sortie de l'amplificateur-inverseur, que l'ensemble de commutation comprend un premier dispositif commutateur comprenant au moins deux contacts ($S_d$) connectés d'une part respectivement à l'autre côté de la résistance première nommée ($Rp_o$) ainsi qu'au point milieu du ou des diviseurs résistifs ($Rs_c$, $Rp_c$), et d'autre part en commun à l'entrée de l'amplificateur-inverseur, que le second jeu de résistances, monté en parallèle entre la borne de tension de référence et l'entrée de l'amplificateur inverseur, comprend d'autres résistances ($R_1$ à $R_8$) mises en série sur des contacts respectifs ($S_1$ à $S_8$) formant un second dispositif commutateur au sein de l'ensemble de commutation, et que les moyens de commande de commutation agissent sur l'état des contacts du premier et du second commutateur respectivement en fonction d'au moins un poids supérieur et des autres poids inférieurs de la valeur numérique appliquée aux bornes d'entrée, un et un seul des contacts du premier commutateur étant fermé à chaque fois, et par le fait que, K désignant un facteur prédéterminé, $\varepsilon$ une petite quantité d'approximation choisie à l'avance, et $R_{min}$ représentant la résistance équivalente à l'ensemble parallèle des résistances ($R_1$ à $R_8$) dudit second jeu,

— la résistance $R_{po}$ est sensiblement égale à

$$\frac{K}{U} \cdot R_{min} \cdot \sin\left(\frac{\pi}{2} \cdot \frac{1}{m+1} + \frac{\varepsilon}{2}\right)$$

— la ou les résistances $Rp_c$ sont, d'après la valeur de leur indice c, sensiblement égales à

$$\frac{K}{U} \cdot R_{min} \cdot \left[\sin\left(\frac{\pi}{2} \cdot \frac{c+1}{m+1} + \frac{\varepsilon}{2}\right) - \sin\left(\frac{\pi}{2} \cdot \frac{c}{m+1} + \frac{\varepsilon}{2}\right)\right]$$

— et la ou les résistances $Rs_c$ sont, d'après la valeur de leur indice c, sensiblement égales à

$$\frac{U}{K} \cdot \frac{1}{\sin\left(\frac{\pi}{2} \cdot \frac{c}{m+1} + \frac{\varepsilon}{2}\right)} \cdot Rp_c,$$

la sortie analogique de l'amplificateur constituant alors une approximation par segments de droite sur un quadrant d'une fonction sinusoïdale de la valeur numérique d'entrée.

2. Circuit selon la revendication 1, caractérisé par le fait que les résistances ($R_1$ à $R_8$) dudit second jeu sont entre elles comme les puissances successives de deux, et que le nombre m est égal à 3 ou 7.

3. Circuit selon l'une des revendications 1 et 2, caractérisé par le fait que les moyens de commande agissent directement sur les contacts ($S_1$ à $S_8$) du second commutateur, et par l'intermédiaire d'un décodeur sur les contacts ($S_d$) du premier commutateur, en fonction du ou des poids supérieurs de la valeur numérique d'entrée.

4. Circuit selon l'une des revendications 1 à 3, caractérisé par le fait qu'il comporte un second amplificateur-inverseur connecté à la sortie du premier, et agencé pour delivrer une sortie de même amplitude que lui, mais de signe opposé.

5. Circuit selon la revendication 4, dans lequel la quantité numérique à convertir comporte deux poids encore supérieurs indiquant dans quel quadrant du cercle trigonométrique se situe la grandeur d'entrée, caractérisé par le fait qu'il comporte des moyens aptes à complémenter tous les autres poids de la grandeur numérique d'entrée, et des moyens de sélection capables de choisir d'effectuer ou non cette complémentation ainsi que de prendre la sortie de l'un ou l'autre des deux amplificateurs-inverseurs en fonction desdits deux poids encore superieurs.

6. Circuit selon la revendication 5, caractérisé par le fait qu'il comporte un second circuit selon la revendication 4 connecté à la sortie des moyens aptes à complémenter tous les autres poids, et que les moyens de sélection sont connectés aux deux circuits semblables, et agencés pour fournir en même temps le sinus et le cosinus de la grandeur d'entrée, ce qui fournit un convertisseur numérique-résolveur.

7. Circuit selon la revendication 6, caractérisé par le fait qu'il comporte en outre un transformateur de Scott, ce qui fournit un convertisseur numérique-synchromachine triphasée.

8. Convertisseur résolveur-numérique, à partir de deux tensions analogiques d'entrée respectivement représentatives du sinus et du cosinus d'un angle $\varphi$, caractérisé par le fait qu'il comporte un premier et un second circuit construits chacun selon la revendication 4, dont l'un est équipé en outre d'un moyen pour complémenter sa grandeur numérique d'entrée, un compteur-décompteur apte à fournir en parallèle n chiffres $b_1$ à $b_n$ de poids croissants, destinés à représenter la valeur numérique d'un angle $\theta$, un circuit d'aiguillage d'entrée qui réagit aux poids supérieurs de celle-ci en appliquant selon une loi de commutation préétablie l'un et l'autre des signaux d'entrée à l'un et l'autre des premier et second circuits numériques-analogiques, comme tension de référence, ces deux circuits recevant les autres poids du compteur-décompteur comme entrée numérique, l'un directement, l'autre à travers la

**0018918**

complémentation à lui associée, un circuit d'addition anagogique des sorties des deux circuits numériques-analogiques, le circuit d'aiguillage et ce circuit d'addition analogique étant agencés avec des polarités telles que la sortie additive soit de la forme

$$\sin\varphi\cos\theta - \sin\theta\cos\varphi = \sin(\varphi - \theta)$$

et un moyen de servo-commande qui fait évoluer le compteur-décompteur de manière à annuler la sortie additive analogique.

9. Circuit selon la revendication 8, dans lequel les deux tensions analogiques d'entrée sont constituées respectivement par une fréquence porteuse modulée en amplitude suivant le sinus et le cosinus de l'angle $\varphi$, caractérisé par le fait que le moyen de servo-commande comprend un démodulateur synchrone piloté par cette fréquence porteuse.

10. Circuit selon l'une des revendications 8 et 9, caractérisé par le fait que le moyen de servo-commande comprend un détecteur de polarité qui commande le comptage ou le décomptage dans le compteur-décompteur, et un convertisseur tensio-fréquence qui définit la fréquence d'horloge appliquée à ce même compteur-décompteur.

**Patentansprüche**

1. Digital/Analog-Umsetzerschaltung mit sinusoidaler Charakteristik, welche eine Klemme für eine Bezugsspannung U zur Bestimmung des Maßstabes der Umsetzung, Klemmen für die Digitaleingabe einer Folge ($b_1$ bis $b_{n-2}$) von Ziffern, die mit vorbestimmten Stellenwerten den numerischen Betrag wenigstens in Bruchteilen eines Viertels des vollen Kreiswinkels darstellen, einen invertierenden Verstärker, einen ersten Satz von Widerständen zur Bildung eines Spannungsteilers, von dem ein Ende mit dem Ausgang und die Anzapfung mit dem invertierenden Eingang des invertierenden Verstärkers verbunden sind, einen zweiten Satz von Widerständen zur Bildung eines Netzwerkes für die Digital/Analog-Umsetzung und eine Schalteinrichtung aufweist, die unter der Wirkung von Schalt-Steuermitteln in Abhängigkeit von am Eingang einlangenden Ziffern wahlweise den ersten und den zweiten Satz von Widerständen anschließt, so daß das analoge Ausgangssignal des invertierenden Verstärkers eine Näherung der Sinusfunktion des numerischen Wertes der Eingangsgröße durch Geradenabschnitte liefert, dadurch gekennzeichnet, daß der erste Satz von Widerständen einen einzelnen Widerstand ($R_{Po}$), von welchem ein Anschluß mit dem Ausgang des invertierenden Verstärkers verbunden ist, sowie eine Anzahl $m \geq 1$ ohmscher Spannungsteiler ($R_{Sc}$, $R_{Pc}$) enthält, welche zwischen der Bezugsspannungsklemme und dem Ausgang des invertierenden Verstärkers angeschlossen sind, daß die Schalteinrichtung eine erste Schalteranordnung mit wenigstens zwei Schalterkontakten ($S_d$) aufweist, die einerseits mit dem anderen Anschluß des einen einzelnen Widerstandes ($R_{Po}$) bzw. mit der bzw. den Anzapfung(en) des bzw. der ohmschen Spannungsteiler(s) ($R_{Sc}$, $R_{Pc}$) und anderseits gemeinsam mit dem Eingang des invertierenden Verstärkers verbunden sind, daß der zweite Satz von Widerständen, die parallel zwischen der Bezugsspannungsklemme und dem Eingang des invertierenden Verstärkers liegen, andere Widerstände ($R_1$ bis $R_8$) enthält, die je mit einem Schalterkontakt ($S_1$ bis $S_8$) einer zweiten Schalteranordnung der Schalteinrichtung in Reihe geschaltet sind, daß die Schalt-Steuermittel auf die Schalterkontakte der ersten und der zweiten Schalteranordnung in Abhängigkeit von wenigstens einem hohen Stellenwert bzw. von den anderen, niedrigen Stellenwerten des numerischen Betrages an den Eingangsklemmen einwirken, wobei stets nur eine Schaltkontakt der ersten Schalteinrichtung geschlossen ist, und daß K ein vorbestimmter Faktor, $\varepsilon$ eine kleine vorgewählte Näherungsgröße und $R_{min}$ der äquivalente Widerstand der Parallelschaltung der Widerstände ($R_1$ bis $R_8$) des zweiten Satzes ist, der Widerstand $R_{Po}$ im wesentlichen gleich

$$(K/U) \cdot R_{min} \cdot \sin[(\pi/2) \cdot 1/(m+1) + \varepsilon/2]$$

ist, der Widerstand oder die Widerstände $R_{Pc}$ entsprechend dem Index c im wesentlichen gleich

$$(K/U) \cdot R_{min} \cdot \{\sin[(\pi/2) \cdot (c+1)/(m+1) + \varepsilon/2] - \sin[(\pi/2) \cdot c/(m+1) + \varepsilon/2]\}$$

ist bzw. sind und der Widerstand oder die Widerstände $R_{Sc}$ entsprechend dem Index c im wesentlichen gleich

$$(U/K) \cdot \{1/\sin[(\pi/2) \cdot c/(m+1) + \varepsilon/2]\} \cdot R_{Pc}$$

ist bzw. sind, wobei das analoge Ausgangssignal des Verstärkers dann eine Näherung für einen Quadranten der Sinusfunktion des numerischen Wertes der Eingangsgröße durch Geradenabschnitte darstellt.

2. Schaltung nach Anspruch 1, dadurch gekennzeichnet, daß sich die Werte der Widerstände ($R_1$ bis $R_8$) des zweiten Satzes zueinander wie aufeinanderfolgende Potenzen der Zahl 2 verhalten und daß m gleich 3 oder 7 ist.

9

3. Schaltung nach Anspruch 1 oder 2, dadurch gekennzeichnet, daß die Schalt-Steuermittel auf die Schalterkontakte ($S_1$ bis $S_8$) der zweiten Schalteranordnung unmittelbar und auf die Schalterkontakte ($S_d$) der ersten Schalteranordnung mittelbar über einen Decoder in Abhängigkeit von dem oder den hohen Stellenwert(en) des numerischen Wertes der Eingangsgröße einwirken.

4. Schaltung nach einem der Ansprüche 1 bis 3, dadurch gekennzeichnet, daß sie einen an den Ausgang des ersten invertierenden Verstärkers angeschlossenen zweiten invertierenden Verstärker aufweist, der ein Ausgangssignal gleicher Amplitude, jedoch mit umgekehrten Vorzeichen abgibt.

5. Schaltung nach Anspruch 4, bei welcher die umzusetzende numerische Größe zwei noch höhere Stellenwerte aufweist, die anzeigen, in welchem Quadranten die Eingangsgröße liegt, dadurch gekennzeichnet, daß sie Mittel zur Komplementbildung aller anderen Stellenwerte der numerischen Eingangsgröße sowie Wählmittel zum Wählen des Ausführens oder Nichtausführens der Komplementbildung sowie des Ausgangs des einen oder des anderen invertierenden Verstärkers in Abhängigkeit von den zwei genannten noch höheren Stellenwerten enthält.

6. Schaltung nach Anspruch 5, dadurch gekennzeichnet, daß sie eine zweite Schaltung nach Anspruch 4 aufweist, die an den Ausgang der Mittel zur Komplementbildung aller anderen Stellenwerte angeschlossen ist, und daß die Wählmittel und die beiden gleichartigen Schaltungen angeschlossen sind und so betrieben sind, daß sie gleichzeitig den Sinus und den Cosinus der Eingangsgröße liefern, so daß ein Digital/Resolver-Wandler gebildet ist.

7. Schaltung nach Anspruch 6, dadurch gekennzeichnet, daß sie außerdem einen Scott-Transformator zur Bildung eines Digital/Synchro-Wandlers enthält.

8. Resolver/Digital-Wandler, ausgehend von zwei analogen Eingangsspannungen, die ein Maß für den Sinus bzw. den Cosinus eines Winkels $\varphi$ darstellen, gekennzeichnet durch eine erste und eine zweite Schaltung, deren jede nach Anspruch 4 ausgebildet ist, von denen eine außerdem mit Mitteln zur Komplementbildung ihrer numerischen Eingangsgröße ausgestattet ist, einen Vorwärts/Rückwärts-Zähler für die parallele Lieferung von n Ziffern $b_1$ bis $b_n$ mit zunehmendem Stellenwert zur Darstellung des numerischen Wertes eines Winkels $\theta$, eine auf hohe Stellenwerte der Eingangssignale ansprechende Eingangs-Steuerschaltung, die nach einer vorbestimmten Schaltvorschrift das eine und andere Eingangssignal an die eine und die andere der ersten und zweiten Digital/Analogschaltung als Bezugsspannung anlegt, welche beiden Schaltungen die anderen Stellenwerte des Vorwärts/Rückwärts-Zählers als digitale Eingangssignale empfangen, u.zw. die eine direkt und die andere über eine ihre zugeordnete Komplementbildung, eine mit den Ausgängen der beiden Digital/Analogschaltungen verbundene Analog-Addierschaltung, wobei die Steuerschaltung und diese Analog-Addierschaltung mit Polaritäten derart betrieben werden, daß das Summenausgangssignal in der Form

$$\sin \varphi \cdot \cos \theta - \sin \theta \cdot \cos \varphi = \sin(\varphi - \theta)$$

vorliegt, und eine Servosteuervorrichtung, die den Vorwärts/Rückwärts-Zähler in einer Weise steuert, daß das analoge Summenausgangssignal annulliert wird.

9. Schaltung nach Anspruch 8, bei welcher die beiden analogen Eingangsspannungen als gemäß dem Sinus bzw. dem Cosinus des Winkels $\varphi$ amplitudenmodulierte Trägerfrequenz vorliegen, dadurch gekennzeichnet, daß die Servosteuervorrichtung einen mit der Trägerfrequenz gesteuerten Synchrondemodulator enthält.

10. Schaltung nach Anspruch 8 oder 9, dadurch gekennzeichnet, daß die Servosteuervorrichtung einen den Vorwärts- oder Rückwärts-Zählmodus des Vorwärts/Rückwärts Zählers steuernden Polaritätsdetektor und einen Spannungs/Frequenz-Wandler aufweist, welcher die an den Vorwärts/Rückwärts-Zähler angelegte Taktfrequenz bestimmt.

**Claims**

1. A digital-analog conversion circuit having a sinusoidal characteristic, of the type comprising:

— a terminal for receiving a reference voltage U defining the analog conversion scale,
— digital input terminals for receiving a series ($b_1$ to $b_{n-2}$) of numbers representing, in a predetermined weight order, the numerical value of an angle at least in fractions of a quadrant,
— an amplifier-inverter,
— a first set of resistors which are arranged to form a potential divider, one end terminal of which is connected to the output of the amplifier-inverter, and the middle terminal is connected to the inverting input of the amplifier-inverter,
— a second set of resistors forming a digital-analog converter network, and
— a switching assembly capable of interconnecting selectively, under the effect of switching control means as a function of the input numbers, the first and second set of resistors so as to provide at the analog output of the amplifier-inverter an approximation by straight-line segments of a sinusoidal function of the numerical value of the input,

characterised in that the first set of resistors comprises a resistance ($Rp_o$) connected on one side to the output of the amplifier-inverter, and a number $m$ greater than or equal to 1, of resistive dividers ($Rs_c$,

$Rp_c$) mounted between the reference voltage terminal and the output of the amplifier-inverter, the switching assembly comprises a first switching device having at least two contacts ($S_d$) connected on the one hand to the other side of the first mentioned resistor ($Rp_o$) and to the centre point of the resistive divider or dividers ($Rs_c$, $Rp_c$) respectively, and on the other hand, in common to the input of the amplifier-inverter, the second set of resistors arranged in parallel between the reference voltage terminal and the input of the amplifier-inverter comprises further resistors ($R_1$ to $R_8$) arranged in series with respective contacts ($S_1$ to $S_8$) forming a second switching device in the switching assembly, and switching control means act on the condition of the contacts of the first and second switches respectively as a function of at least one greater weight and the other lesser weights of the numerical value applied to the input terminals, one and one alone of the contacts of the first switch being closed each time, and with K designating a predetermined factor, $\varepsilon$ designating a small approximation quantity selected in advance, and $R_{min}$ representing the resistor equivalent to the parallel assembly of the resistors ($R_1$ to $R_8$) of said second set,

— the resistor $R_{po}$ is substantially equal to:

$$\frac{K}{U} \cdot R_{min} \cdot \sin\left(\frac{\pi}{2} \cdot \frac{1}{m+1} + \frac{\varepsilon}{2}\right)$$

the resistor or resistors $Rp_c$, according to the value of their index $c$, are substantially equal to:

$$\frac{K}{U} \cdot R_{min} \cdot \left[\sin\left(\frac{\pi}{2} \cdot \frac{c+1}{m+1} + \frac{\varepsilon}{2}\right) - \sin\left(\frac{\pi}{2} \cdot \frac{c}{m+1} + \frac{\varepsilon}{2}\right)\right]$$

— and the resistor or resistors $Rs_c$, according to the value of their index $c$, are substantially equal to

$$\frac{U}{K} \cdot \frac{1}{\sin\left(\dfrac{\pi}{2} \cdot \dfrac{c}{m+1} + \dfrac{\varepsilon}{2}\right)} \cdot Rp_c,$$

the analog output of the amplifier then forming an approximation by straight line segments over a quadrant of a sinusoidal function of the numerical value of the input.

2. A circuit according to claim 1, characterised in that the resistors ($R_1$ to $R_8$) of said second set area in relation to one another, in accordance with the successive powers of two, and the number $m$ is equal to 3 or 7.

3. A circuit according to one of claims 1 and 2, characterised in that the control means act directly on the contacts ($S_1$ to $S_8$) of the second switch, and they act via the intermediary of a decoder on the contacts ($S_d$) of the first switch, as a function of the greater weight of weights of the numerical value of the input.

4. A circuit according to one of claims 1 to 3, characterised in that it comprises a second amplifier-inverter connected to the output of the first amplifier-inverter, and arranged to deliver an output of the same amplitude as the first, but of an opposite sign.

5. A circuit according to claim 4, wherein the digital quantity to be converted comprises two weights which are still higher; indicating in which quadrant of the trigonometric circle the input magnitude is located, characterised in that it comprises means which are capable of complementing all the other weights of the numerical magnitude of the input, and comprises selection means capable of choosing whether to perform this complementation or not, and to take the output of the one or other of the two amplifier-inverters as a function of said two still higher weights.

6. A circuit according to claim 5, characterised in that it comprises a second circuit according to claim 4 which is connected to the output of the means capable of complementing all the other weights, and the selection means are connected to the two similar circuits and are arranged to provide at the same time, the sine and the cosine of the magnitude of the input, which supplies a digital-resolver converter.

7. A circuit according to claim 6, characterised in that it also comprises a Scott transformer, which supplies a threephase digital-synchronous machine converter.

8. A resolver-digital converter, from two input analog voltages respectively representing of the sine and the cosine of an angle $\varphi$, characterised in that the converter comprises a first circuit and a second circuit, each being constructed according to claim 4, one of which is equipped, moreover, with a means for complementing its input numerical magnitude, a counter-deductor capable of providing in parallel $n$ numbers $b_1$ to $b_n$ of increasing weights which are to represent the numerical value of an angle $\theta$, an input switching circuit which reacts to the greater weights of the latter by applying according to a predetermined switching law, the one and other of the input signals to the one and other of the first and second digital-analog circuits as a reference voltage, these two circuits receiving the other weights of the counter-deductor as a digital input, one directly, the other through the complementation association therewith, an analog addition circuit of the outputs of the two digital-analog circuits, the switching circuit and this analog addition circuit being arranged with polarities such that the additive output is of the form:

$$\sin \varphi \cos \theta - \sin \theta \cos \varphi = \sin(\varphi - \theta)$$

and servo-control means which cause the counter-deductor to operate so as to cancel the analog additive output.

9. A circuit according to claim 8, wherein the two analog input voltages are formed respectively by a carrier frequency, modulated in amplitude according to the sine and the cosine of the angle $\varphi$, characterised in that the servo-control means comprise a synchronous demodulator driven by this carrier frequency.

10. A circuit according to one of claims 8 and 9, characterised in that the servo-control means comprise a polarity detector which controls the counting or the deduction in the counter-deductor, and comprise a voltage-frequency converter which defines the clock frequency applied to this same counter-deductor.

**0018918**

FIG_1

FIG_2

**0018918**

FIG_3

FIG_4

FIG_5

| Quadrant | $b_n\ b_{n-1}$ | $\sin\theta$ | $\cos\theta$ |
|----------|----------------|--------------|--------------|
| 1 | 00 | sin | cos |
| 2 | 01 | cos | − sin |
| 3 | 10 | − sin | − cos |
| 4 | 11 | − cos | sin |

**0018918**

FIG_6

71 — GENERATEUR SINUS

SQ2

R sin φ

Sélecteur de Quadrant

R cos φ

Entrées Analogiques venant du resolver

b(n-2)   b₁

72 — GENERATEUR SINUS

66 — (+)

67 — Démodulateur Synchrone

400 Hz

bₙ   b(n-1)

65 — INVERSEUR

b(n-2)   b₁

68 — DÉTECTEUR DE POLARITÉ

60 — Compteur / Décompteur

Compte / Décompte

69 — CONVERSION TENSION / FRÉQUENCE

Horloge

bn   b₁

θ

SQ2

FIG_7

sin φ

61

− sin φ

cos φ

62

− cos φ

Sa 00   Sa 01   Sa 10   Sa 11   vers 71

Sb 00   Sb 01   Sb 10   Sb 11   vers 72

00   01   10   11

DCR 3 — DÉCODEUR

bn-1   bn

FIG_8

| Quadrant | bₙ bₙ₋₁ | Entrée 71 | Entrée 72 |
|----------|---------|-----------|-----------|
| 1 | 00 | sin φ | cos φ |
| 2 | 01 | − cos φ | sin φ |
| 3 | 10 | − sin φ | − cos φ |
| 4 | 11 | cos φ | − sin φ |

3